# EUROPEAN PATENT SPECIFICATION

(11) **EP 2 023 355 B1**
(45) Date of publication and mention of the grant of the patent: **06.04.2016**
(21) Application number: 07741959.6
(22) Date of filing: 19.04.2007
(51) Int. Cl.: H01F 19/06, H01F 17/00, H01F 27/29

(54) **LAYERED TYPE BALUN TRANSFORMER**
BALUN-TRANSFORMATOR DES GESCHICHTETEN TYPS
TRANSFORMATEUR SYMÉTRIQUE-ASYMÉTRIQUE MULTICOUCHE

(30) Priority: 01.06.2006 JP 2006153210
(43) Date of publication of application: 11.02.2009
(73) Proprietor: Murata Manufacturing Co., Ltd., Nagaokakyo-shi, Kyoto 617-8555 (JP)
(72) Inventor: ISHIDA, Kosuke, Nagaokakyo-shi, Kyoto 617-8555 (JP)
(74) Representative: Reeve, Nicholas Edward
(86) International application number: PCT/JP2007/058523
(87) International publication number: WO 2007/138800

(56) References cited:
- EP-A1- 1 383 145
- WO-A1-2006/057115
- WO-A1-2006/123485
- JP-A- 07 176 918
- JP-A- 08 191 016
- JP-A- 11 214 943
- JP-A- 2002 359 507
- JP-A- 2004 350 143
- JP-A- 2005 333 011
- JP-A- 2006 013 063
- US-A1- 2002 153 988

## Description

### Technical Field

The present invention relates to a laminated balun transformer used as a balance-unbalance converter for an IC of a cellular phone, an antenna of a television receiver, or the like.

### Background Art

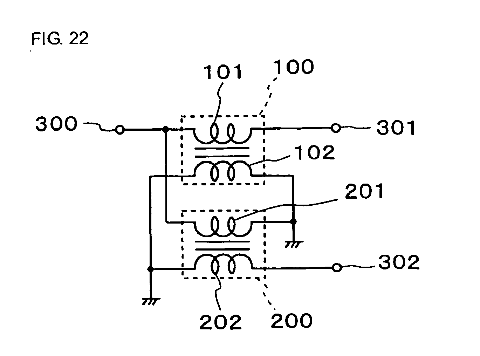

The balun transformer includes a first transformer 100 and a second transformer 200 as shown in an equivalent circuit diagram of FIG. 22. Then, coils 101 and 102 that form the first transformer 100 and coils 201 and 202 that form the second transformer 200 are connected as shown in the drawing to thereby set the ratio of an impedance of a side of an unbalance terminal 300 to an impedance of a side of balance terminals 301 and 302 to 1 to 4. In the existing art, Japanese patent applications 04-206905 or 06-120428, for example, describes a technology for a laminated balun transformer that has a circuit structure of the above type. These laminated balun transformers are formed so that coil conductive patterns for forming coils of the first and second transformers 100 and 200 or magnetic sheets and nonmagnetic sheets are laminated. Thus, the size is reduced.

However, the above described existing laminated balun transformers have the following problems. In the balun transformer, generally, when the impedance of the unbalance terminal side is set to 1, the impedance of the balance terminal side is the square of the number of transformers. For example, when the number of transformers is 1, the ratio of an unbalance terminal-side impedance to a balance terminal-side impedance is 1 to 1. As shown in FIG. 22, when the number of transformers is 2, the ratio of an unbalance terminal-side impedance to a balance terminal-side impedance is 1 to 4 (the square of 2). Thus, when the ratio of an impedance of a balance terminal side to an unbalance terminal needs to be changed, it is only necessary to change the number of transformers. However, the ratio of an impedance of the balance terminal side to the unbalance terminal takes discrete values, such as 1, 4, 9, ..., and, therefore, a difference between the adjacent ratios is large. Thus, when the line of the balance terminal side to the line of the unbalance terminal side has a ratio of impedance, such as 2, 3, 6, ..., the existing balun transformer cannot be used. That is, the existing balun transformer is not versatile and cannot be applied to the lines of various impedances.

We have appreciated that it would be desirable to provide a laminated balun transformer that may be applied to the lines having various impedances.

### SUMMARY OF INVENTION

In a first aspect of the invention there is provided a laminated balun transformer. The laminated balun transformer includes: a first magnetic substrate; a laminated body that incorporates a first transformer and a second transformer, each of which is formed of a primary coil and a secondary coil that are laminated on the first magnetic substrate and that face each other; and a second magnetic substrate provided on the laminated body, wherein one end of the primary coil of the first transformer serves as an unbalance terminal and the other end of the primary coil serves as a first balance terminal, one end and the other end of the secondary coil respectively serve as ground terminals, one end of the primary coil of the second transformer is connected to the one end of the primary coil of the first transformer and the other end of the primary coil of the first transformer is connected to the secondary coil of the first transformer, one end of the secondary coil of the second transformer is connected to the one end of the secondary coil of the first transformer and the other end of the secondary coil of the second transformer serves as a second balance terminal, and wherein the shape of the primary coil of the first transformer is set so that the line width of the primary coil of the first transformer increases or decreases from the one end toward the other end, and the shape of the secondary coil of the second transformer is set so that the line width of the secondary coil of the second transformer increases or decreases from the one end toward the other end. With the above configuration, the shape of the primary coil of the first transformer is set so that the line width of the primary coil of the first transformer increases from the one end toward the other end, and the shape of the secondary coil of the second transformer is set so that the line width of the secondary coil of the second transformer increases from the one end toward the other end. Thus, the ratio of an impedance of the unbalance terminal side to an impedance of the first and second balance terminal sides may be smaller than 1 to 4, such as 1 to 3. In addition, the shape of the primary coil of the first transformer is set so that the line width of the primary coil of the first transformer decreases from the one end toward the other end, and the shape of the secondary coil of the second transformer is set so the line width of the secondary coil of the second transformer decreases from the one end toward the other end. Thus, it may be larger than 1 to 4, such as 1 to 6.

In a second aspect of the invention there is provided a laminated balun transformer. The laminated balun transformer includes: a first magnetic substrate; a laminated body that incorporates a transformer formed of a primary coil and a secondary coil that are laminated on the first magnetic substrate and that face each other; and a second magnetic substrate that is provided on the laminated body, wherein one end of the primary coil of the transformer serves as an unbalance terminal and the other end of the primary coil serves as a first balance terminal, and one end of the secondary coil serves as a ground terminal and the other end of the secondary coil serves as a second balance terminal, and wherein the shape of the primary coil of the transformer and the shape of the secondary coil of the transformer are set so that the line width of the primary coil and the line width of the secondary coil increase or decrease from the one end toward the other end. With the above configuration, the shapes of the coils are set so that the line width of the primary coil and the line width of the secondary coil increase from the one end toward the other end. Thus, the ratio of an impedance of the unbalance terminal side to an impedance of the first and second balance terminal sides may be smaller than 1 to 1, such as 1 to 0.5. In addition, the shapes of the coils are set so that the line width of the primary coil and the line width of the secondary coil decrease from the one end toward the other end. Thus, the ratio may be larger than 1 to 1, such as 1 to 2.

In a third aspect of the invention there is provided a laminated balun transformer. The laminated balun transformer includes: a first magnetic substrate, a laminated body that incorporates a first transformer to an nth transformer (n is integer larger than or equal to 3), which are laminated on the first magnetic substrate and each of which is formed of a primary coil, and a secondary coil that face each other; and a second magnetic substrate that is provided on the laminated body, wherein one end of the primary coil of the first transformer serves as an unbalance terminal and the other end of the primary coil of the first transformer serves as a first balance terminal, one end of the secondary coil of the nth transformer serves as a ground terminal and the other end of the secondary coil of the nth transformer serves as a second balance terminal, one ends of the secondary coils of the first transformer to (n-1)th transformer are connected to the one end of the secondary coil of the nth transformer, one ends of the primary coil of the second transformer to nth transformer are connected to the one end of the primary coil of the first transformer and the other ends of the primary coils of the second transformer to nth transformer are respectively connected to the other ends of the secondary coils of the preceding transformers, and wherein the shape of the primary coil of the first transformer is set so that the line width of the primary coil of the first transformer increases or decreases from the one end toward the other end, and the shape of the secondary coil of the nth transformer is set so that the line width of the secondary coil of the nth transformer increases or decreases from the one end toward the other end. With the above configuration, the shape of the primary coil of the first transformer is set so that the line width of the primary coil of the first transformer increases from the one end toward the other end, and the shape of the secondary coil of the nth transformer is set so that the line width of the secondary coil of the nth transformer increases from the one end toward the other end. Thus, the ratio of an impedance of the unbalance terminal side to an impedance of the balance terminal sides may be smaller than 1 to n². In addition, the shape of the primary coil of the first transformer is set so that the line width of the primary coil of the first transformer decreases from the one end toward the other end, and the shape of the secondary coil of the nth transformer is set so the line width of the secondary coil of the nth transformer decreases from the one end toward the other end. Thus, it may be larger than 1 to n².

As described in detail above, according to the invention, the ratio of an impedance of the balance terminal side to the unbalance terminal may be selectively set to a ratio that conforms to the impedance of a line to be mounted, not only in discrete values, such as 1, 4, 9, ..., but also in 2, 3, 6, ..., or the like. Thus, it is possible to advantageously provide a versatile laminated balun transformer that may be mounted at low insertion loss in lines of various impedances.

### BRIEF DESCRIPTION OF DRAWINGS

FIG. 1 is an exploded perspective view of a laminated balun transformer according to a first embodiment of the invention.
FIG. 2 is an external view of the laminated balun transformer.
FIG. 3 is a plan view of a conductive pattern in a lowermost layer.
FIG. 4 is a plan view of an insulating layer.
FIG. 5 is a plan view of a conductive pattern in a second layer.
FIG. 6 is a schematic plan view that shows a primary coil of a first transformer with it expanded.
FIG. 7 is a plan view of a conductive pattern in a third layer.
FIG. 8 is a plan view of an insulating layer.
FIG. 9 is a plan view of a conductive pattern in an uppermost layer.
FIG. 10 is a schematic plan view that shows a secondary coil of a second transformer with it expanded.
FIG. 11 is a schematic view that shows the electrical configuration of the first and second transformers.
FIG. 12 is a plan view that shows a state where the laminated balun transformer is mounted on lines.
FIG. 13 is an exploded perspective view of a laminated balun transformer according to a second embodiment of the invention.
FIG. 14 is a plan view that shows a lower-layer conductive pattern of a primary coil.
FIG. 15 is a plan view that shows an intermediate insulating layer.
FIG. 16 is a plan view that shows an upper-layer conductive pattern of the primary coil.
FIG. 17 is a plan view that shows a lower-layer conductive pattern of a secondary coil.
FIG. 18 is a plan view that shows an intermediate insulating layer.
FIG. 19 is a plan view that shows an upper-layer conductive pattern of the secondary coil.
FIG. 20 is an equivalent circuit diagram of a laminated balun transformer according to the second embodiment.
FIG. 21 is an equivalent circuit diagram of a laminated balun transformer according to a third embodiment of the invention.
FIG. 22 is an equivalent circuit diagram of a 1 to 4 balun transformer according to an existing example.

### Reference Numerals

1, 3 magnetic substrate
2 laminated body
4-1 to 4-6 external electrode
5 first transformer
5-1, 6-1, 8-1, 9-1 primary coil
6 second transformer
5-2, 6-2, 8-2, 9-2 secondary coil
7 insulator
8 transformer
51 to 54, 61 to 64, 81 to 84 conductive pattern
51 a to 54a, 61 a to 64a internal electrode
51b to 54b, 51 c to 54c, 61b to 64b, 61 c to 64c pattern
71 to 76 insulating layer

### DETAILED DESCRIPTION OF THE PREFERRED EMBODIMENTS

Hereinafter, preferred embodiments of the invention will be described with reference to the accompanying drawings.

### First Embodiment

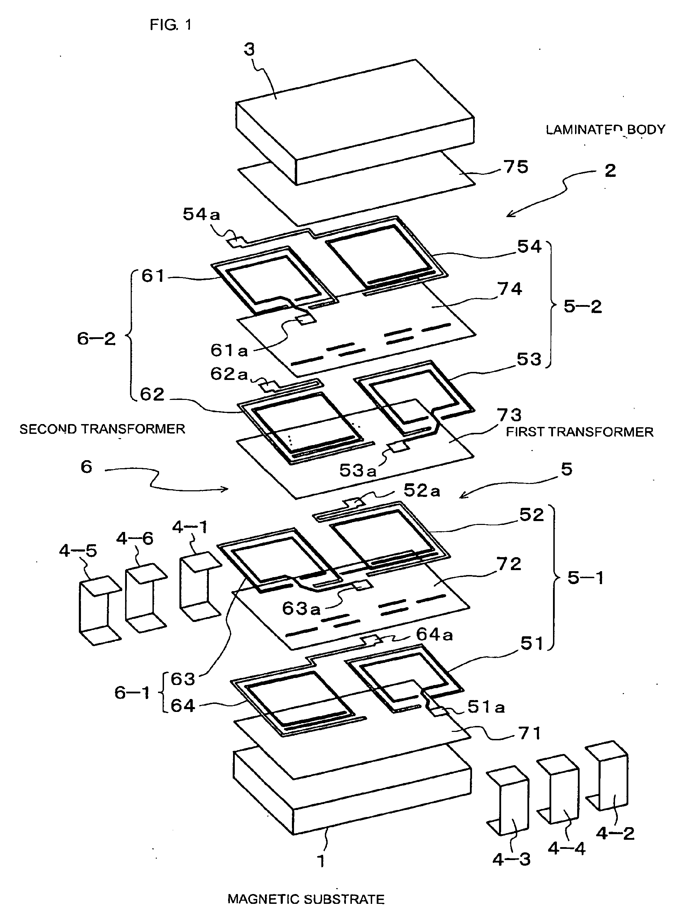

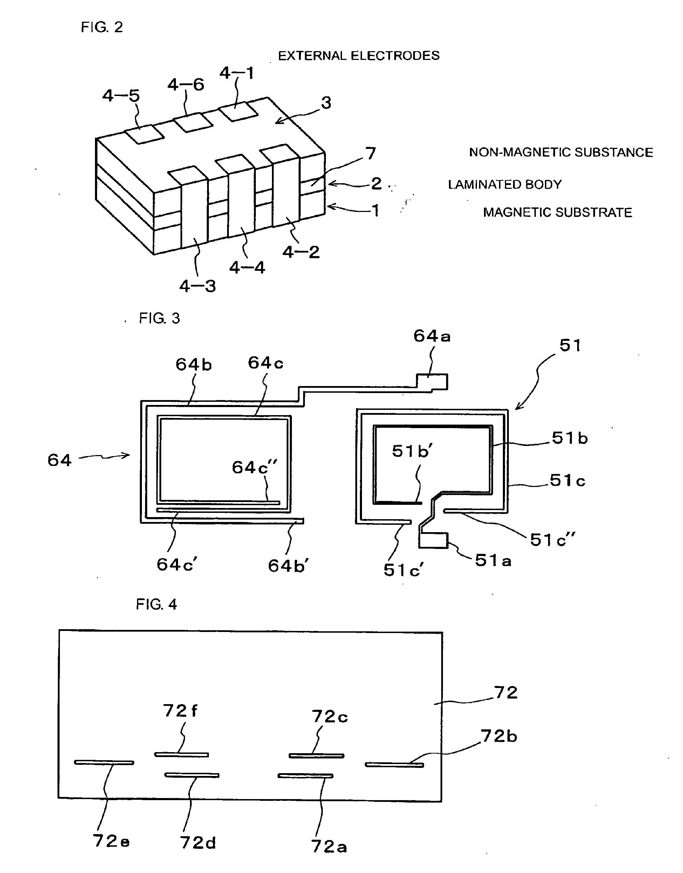

FIG. 1 is an exploded perspective view of a laminated balun transformer according to a first embodiment of the invention. FIG. 2 is an external view of the laminated balun transformer.

As shown in FIG. 2, in this embodiment, a laminated balun transformer includes a magnetic substrate 1 which serves as a first magnetic substrate, a laminated body 2 laminated on the magnetic substrate 1, a magnetic substrate 3 which serves as a second magnetic substrate that is bonded onto the laminated body 2, and external electrodes 4-1 to 4-6.

As shown in FIG. 1, the laminated body 2 includes a first transformer 5, a second transformer 6 that has substantially similar structure to the first transformer 5 and that is oriented in the same direction as the first transformer 5, and an insulator 7 (see FIG. 2) that covers these first and second transformers 5 and 6 from the outside.

The insulator 7 is, for example, a dielectric substance, and is formed by laminating insulating layers 71 to 75. Then, the first and second transformers 5 and 6 are patterned on the above insulating layers 71 to 74. Specifically, the first transformer 5 is formed of a primary coil 5-1 and a secondary coil 5-2 that face each other in a laminating direction. Then, the primary coil 5-1 is formed of a conductive pattern 51 and a conductive pattern 52, and the secondary coil 5-2 is formed of a conductive pattern 53 and a conductive pattern 54. On the other hand, the second transformer 6 is also formed of a primary coil 6-1 and a secondary coil 6-2 that face each other in a laminating direction. Then, the primary coil 6-1 is formed of a conductive pattern 63 and a conductive pattern 64, and the secondary coil 6-2 is formed of a conductive pattern 61 and a conductive pattern 62.

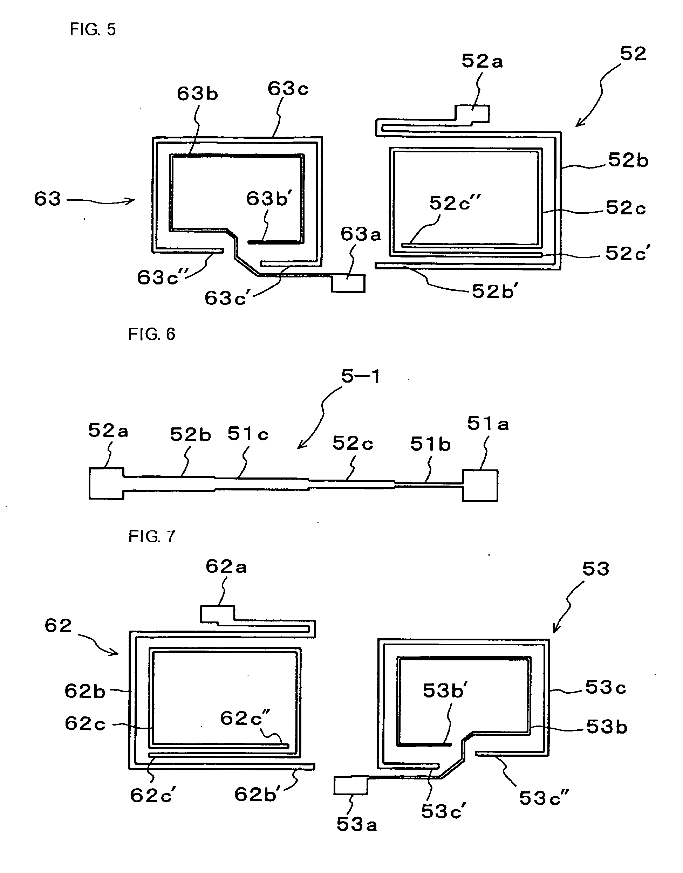

Here, the structures of the first and second transformers 5 and 6 will be described in detail. The conductive patterns 51 and 64 are patterned on the insulating layer 71, which is laminated on the magnetic substrate 1, through photolithography, or the like. Then, the insulating layer 72 is laminated on the conductive patterns 51 and 64, and then the conductive patterns 52 and 63 are patterned on the insulating layer 72. FIG. 3 is a plan view of the conductive patterns 51 and 64. FIG. 4 is a plan view of the insulating layer 72. FIG. 5 is a plan view of the conductive patterns 52 and 63. FIG. 6 is a schematic plan view that shows the primary coil 5-1 of the first transformer 5 with it expanded. As shown in FIG. 3, the conductive pattern 51 is formed of a pattern 51b that includes an internal electrode 51a extended from the inside, and an outside pattern 51c. In addition, as shown in FIG. 5, the conductive pattern 52 is formed of a pattern 52b that includes an internal electrode 52a extended to the outside, and an inside pattern 52c. Then, an end 52b' of the pattern 52b of the conductive pattern 52 is connected to an end 51c' of the pattern 51c of the conductive pattern 51 via a through-hole 72a of the insulating layer 72 shown in FIG. 4. In addition, an end 51 c" of the pattern 51 c is connected to an end 52c' of the pattern 52c via a through-hole 72b, and an end 52c" of the pattern 52c is connected to an end 51 b' of the pattern 51 b via a through-hole 72c. In this manner, the spiral primary coil 5-1 is formed so that the internal electrodes 51a and 52a serve as both ends.

However, in this embodiment, it is formed so that the line width of the pattern 52b is largest, the line widths of the patterns 51c and 52c sequentially become smaller in this order, and the line width of the pattern 51 b is smallest. That is, when the primary coil 5-1 of the first transformer 5 is expanded as shown in FIG. 6, the line width decreases from the side of the internal electrode 52a, which is one end, toward the side of the internal electrode 51 a, which is the other end.

On the other hand, as shown in FIG. 3, the conductive pattern 64 is formed of a pattern 64b that includes an internal electrode 64a extended to an outside center portion (position corresponding to the internal electrode 52a) of the adjacent conductive pattern 51, and an inside pattern 64c. In addition, as shown in FIG. 5, the conductive pattern 63 is formed of a pattern 63b that includes an internal electrode 63a extended from the inside to the center between the conductive patterns 52 and 63, and an outside pattern 63c. Then, an end 64b' of the pattern 64b is connected to an end 63c' of the pattern 63c via a through-hole 72d. In addition, an end 63c" of the pattern 63c is connected to an end 64c" of the pattern 64c via a through-hole 72e, and an end 64c" of the pattern 64c is connected to an end 63b' of the pattern 63b via a through-hole 72f. In this manner, the spiral primary coil 6-1 is formed so that the internal electrodes 64a and 63a serve as both ends and the line width decreases from the side of the internal electrode 64a toward the side of the internal electrode 63a.

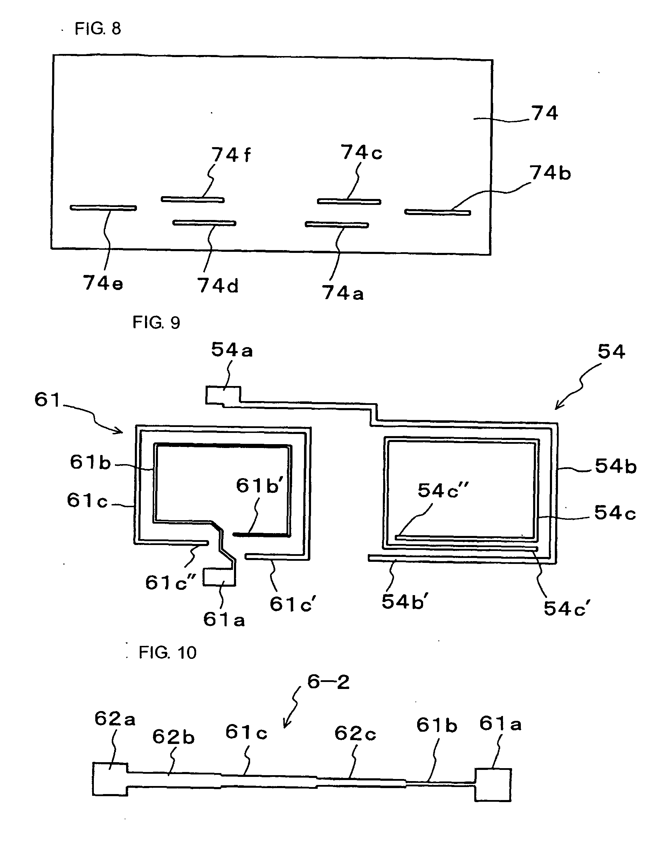

In addition, as shown in FIG. 1, the conductive patterns 53 and 62 are patterned on the insulating layer 73 that is laminated on the conductive patterns 52 and 63. Then, the insulating layer 74 is laminated on the conductive patterns 53 and 62, and then the conductive patterns 54 and 61 are patterned on the insulating layer 74. FIG. 7 is a plan view of the conductive patterns 53 and 62. FIG. 8 is a plan view of the insulating layer 74. FIG. 9 is a plan view of the conductive patterns 54 and 61. FIG. 10 is a schematic plan view that shows the secondary coil 6-2 of the second transformer 6 with it expanded. As shown in FIG. 7, the conductive pattern 53 is formed of an internal electrode 53a extended from the inside to the center between the conductive patterns 53 and 62, and an outside pattern 5cc. In addition, the conductive pattern 54 is formed of a pattern 54b that includes an internal electrode 54a extended to the outside center portion (position corresponding to the internal electrode 62a) of the adjacent conductive pattern 61, and an inside pattern 54c. Then, an end 54b' of the pattern 54b of the conductive pattern 54 is connected to an end 53c' of the pattern 53c of the conductive pattern 53 via a through-hole 74a of the insulating layer 74 shown in FIG. 8. In addition, an end 53c" of the pattern 53c is connected to an end 54c' of the pattern 54c via a through-hole 74b, and an end 54c" of the pattern 54c is connected to an end 53b' of the pattern 53b via a through-hole 74c. In this manner, the spiral secondary coil 5-2 is formed so that the internal electrodes 54a and 53a serve as both ends and the line width decreases from the side of the internal electrode 54a toward the side of the internal electrode 53a.

On the other hand, as shown in FIG. 7, the conductive pattern 62 is formed of a pattern 62b that includes an internal electrode 62a extended to the outside, and an inside pattern 62c. In addition, as shown in FIG. 9, the conductive pattern 61 is formed of a pattern 61 b that includes an internal electrode 61 a extended from the inside, and an outside pattern 61 c. Then, an end 62b' of the pattern 62b is connected to an end 61 c' of the pattern 61 c via a through-hole 74d. In addition, an end 61 c" of the pattern 61 c is connected to an end 62c' of the pattern 62c via a through-hole 74e, and an end 62c" of the pattern 62c is connected to an end 61 b' of the pattern 61 b via a through-hole 74f. In this manner, the spiral secondary coil 6-2 is formed so that the internal electrodes 62a and 61a serve as both ends.

Incidentally, in this embodiment, it is formed so that the line width of the pattern 62b is largest, the line widths of the patterns 61c and 62c sequentially become smaller in this order, and the line width of the pattern 61 b is smallest. That is, as shown in FIG. 10, when the secondary coil 6-2 of the second transformer 6 is expanded, the shape of the secondary coil 6-2 is set so that the line width decreases from the side of the internal electrode 62a, which is one end, toward the side of the internal electrode 61a, which is the other end. Then, as shown in FIG. 1, the insulating layer 75 is laminated on the conductive patterns 54 and 61, and the magnetic substrate 3 is bonded onto the insulating layer 75.

The external electrodes 4-1 to 4-6 are formed on the side face of a chip body having the above described structure. Specifically, the external electrode 4-1 is electrically connected to both the internal electrodes 52a and 64a of the conductive patterns 52 and 64, and the external electrode 4-2 is electrically connected to the internal electrode 51 a of the conductive pattern 51. Then, the external electrode 4-3 is electrically connected to the internal electrode 61 a of the conductive pattern 61, the external electrode 4-4 is electrically connected to both the internal electrodes 53a and 63a of the conductive patterns 53 and 63, and the external electrode 4-5 is electrically connected to both the internal electrodes 54a and 62a of the conductive patterns 54 and 62.

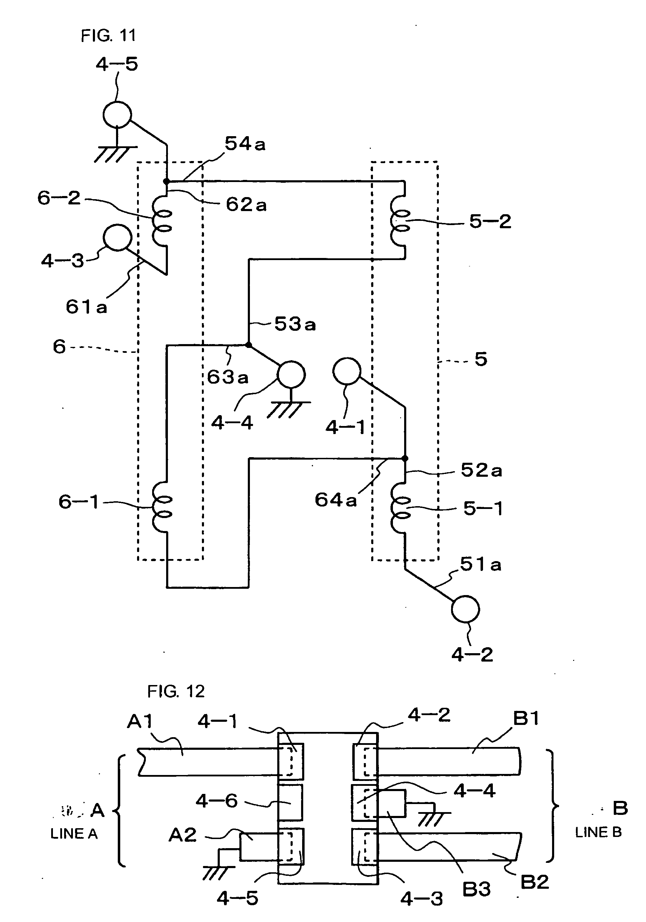

FIG. 11 is a schematic view that shows the electrical configuration of the first and second transformers 5 and 6. Through the above described connection between the conductive patterns and connection between the external electrodes 4-1 to 4-6 and the internal electrodes, the electrical configuration will be a circuit configuration shown in FIG. 11. That is, the external electrode 4-1, which is connected to the internal electrode 52a of the primary coil 5-1 of the first transformer 5, serves as an unbalance terminal, and the external electrode 4-2, which is connected to the internal electrode 51 a, serves as a first balance terminal. Then, the external electrodes 4-4 and 4-5, which are connected to the internal electrodes 53a and 54a that serve as both ends of the secondary coils 5-2, serve as ground terminals. In addition, the internal electrode 64a of the primary coil 6-1 of the second transformer 6 is connected to the internal electrode 52a. Then, the internal electrode 63a is connected to the internal electrode 53a of the secondary coil 5-2 of the first transformer 5 via the external electrode 4-4. Then, the internal electrode 62a of the secondary coil 6-2 is connected to the internal electrode 54a of the secondary coil 5-2 of the first transformer 5. In addition, the external electrode 4-3, which is connected to the internal electrode 61a of the secondary coil 6-2, serves as a second balance terminal. The above circuit configuration is similar to the configuration of the 1 to 4 balun transformer shown in FIG. 22. However, as shown in FIG. 6 and FIG. 10, the laminated balun transformer of this embodiment is formed so that the line width of the primary coil 5-1 of the first transformer 5 is set so as to decrease from the side of the internal electrode 52a toward the side of the internal electrode 51 a, and the line width of the secondary coil 6-2 of the second transformer 6 is set so as to decrease from the side of the internal electrode 62a toward the side of the internal electrode 61 a. Thus, in FIG. 1, the ratio of an impedance of the side of the external electrode 4-1, which is the unbalance terminal, to an impedance of the sides of the external electrodes 4-2 and 4-3, which are the first and second balance terminals, may be set not to 1 to 4 but may be larger than 1 to 4, such as 1 to 5 or 1 to 6.

Next, the function and advantageous effects exhibited by the laminated balun transformer according to this embodiment will be described. FIG. 12 is a plan view that shows a state where the laminated balun transformer is mounted on lines. In FIG. 12, when the characteristic impedance of a line A formed of a signal line A1 and a ground line A2 is 50 Ω, and the characteristic impedance of a line b formed of signal lines B1 and B2 and a ground line B3 is 200 Ω, the 1 to 4 laminated balun transformer shown in FIG. 22 may be used. However, in actual lines, the ratio of characteristic impedances between the line A side and the line B side does not become the ratio of 1 to 4 and largely deviates from the ratio of 1 to 4 in many cases. Even when the existing laminated balun transformer is mounted on the above lines, an appropriate balance characteristic cannot be obtained, and the insertion loss thereof is large. In contrast, in the laminated balun transformer according to this embodiment, as described above, the ratio of an impedance of the side of the external electrode 4-1, which is the unbalance terminal, to an impedance of the sides of the external electrodes 4-2 and 4-3, which are the first and second balance terminals, is set to 1 to 6. Thus, mounting that causes less insertion loss is possible. Specifically, a variation in line width of the primary coil 5-1 of the first transformer 5 and a variation in line width of the secondary coil 6-2 of the second transformer 6 are appropriately set, and the ratio of an impedance of the side of the external electrode 4-1 to an impedance of the sides of the external electrodes 4-2 and 4-3 is set to 1 to 6. Then, in the state as set above, as shown in FIG. 12, the external electrode 4-1, which is the unbalance terminal, is connected to a signal line A1 of the line A side, and the external electrode 4-5 is connected to a ground line A2. The external electrodes 4-2 and 4-3, which are the first and second balance terminals, are connected to signal lines B1 and B2 of the line B side, and the external electrode 4-4 is connected to a ground line B3. Thus, the laminated balun transformer exhibits an appropriate balance characteristic.

The inventors performed a simulation in order to confirm the above assumption. In the simulation, first, a 1 to 4 laminated balun transformer is formed so that the line width of the primary coil 5-1 of the first transformer 5 and the line width of the secondary coil 6-2 of the second transformer 6 are not varied as shown in FIG. 6 or FIG. 10 and the line widths are uniform, and the 1 to 4 laminated balun transformer is mounted between the 50 Ω line A and the 300 Ω line B. Then, insertion losses (dB) with respect to high frequencies of 470 MHz, 750 MHz and 790 MHz were calculated. After that, in the 1 to 4 laminated balun transformer, insertion losses were -0.894 dB, -1.052 dB, and -1.085 dB with respect to high frequencies of 470 MHz, 750 MHz and 790 MHz. Next, the laminated balun transformer of this embodiment is formed so that the line width of the primary coil 5-1 of the first transformer 5 and the line width of the secondary coil 6-2 of the second transformer 6 are varied as shown in FIG. 6 or FIG. 10 to thereby the ratio of the impedances is set to 1 to 6, and the laminated balun transformer is mounted between the 50 Ω line A and the 300 Ω line B. Then, insertion losses (dB) with respect to high frequencies of 470 MHz, 750 MHz and 790 MHz were calculated. Then, in the laminated balun transformer of this embodiment, insertion losses with respect to high frequencies of 470 MHz, 750 MHz and 790 MHz were respectively -0.864 dB, -0.909 dB and -0.923 dB. Thus, it was confirmed that the insertion losses were extremely small.

In this way, according to the laminated balun transformer of this embodiment, the ratio of an impedance of the balance terminal side to the unbalance terminal may be selectively se to a ratio that conforms to the impedance of lines to be mounted, such as 5, 6, 7, .... Thus, the laminated balun transformer may be mounted at low insertion loss in lines of various impedances. Note that in this embodiment, the illustrated laminated balun transformer is formed so that not only the line width of the primary coil 5-1 of the first transformer 5 and the line width of the secondary coil 6-2 of the second transformer 6 but also the line width of the secondary coil 5-2 of the first transformer 5 and the line width of the primary coil 6-1 of the second transformer 6 are varied as shown in FIG. 6 or FIG. 10. However, even when a laminated balun transformer is formed so that only the line width of the primary coil 5-1 and the line width of the secondary coil 6-2 are varied and the line width of the secondary coil 5-2 and the line width of the primary coil 6-1 are uniform, substantially similar function and advantageous effects to those of this embodiment may be obtained.

### Second Embodiment

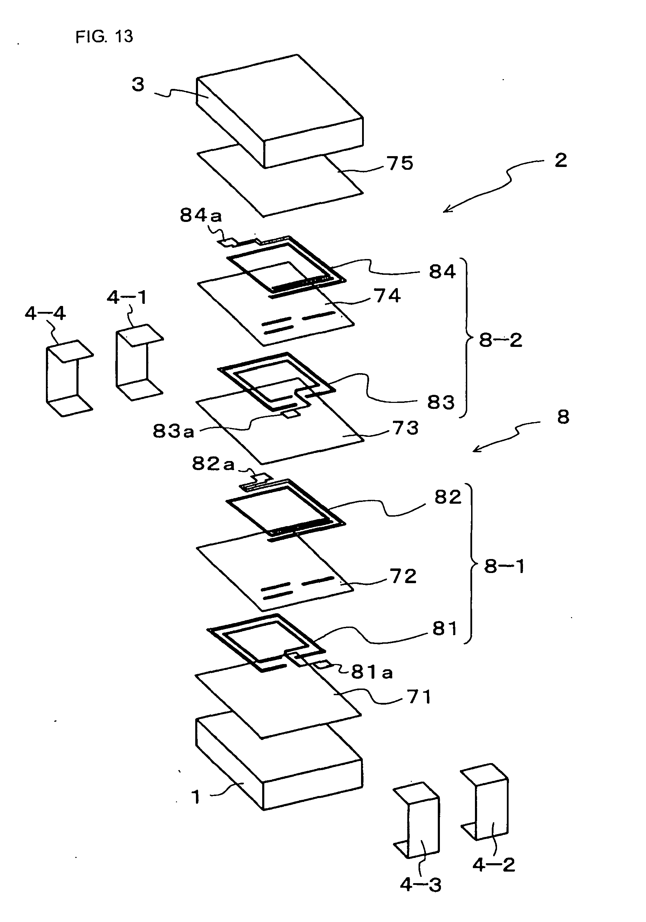

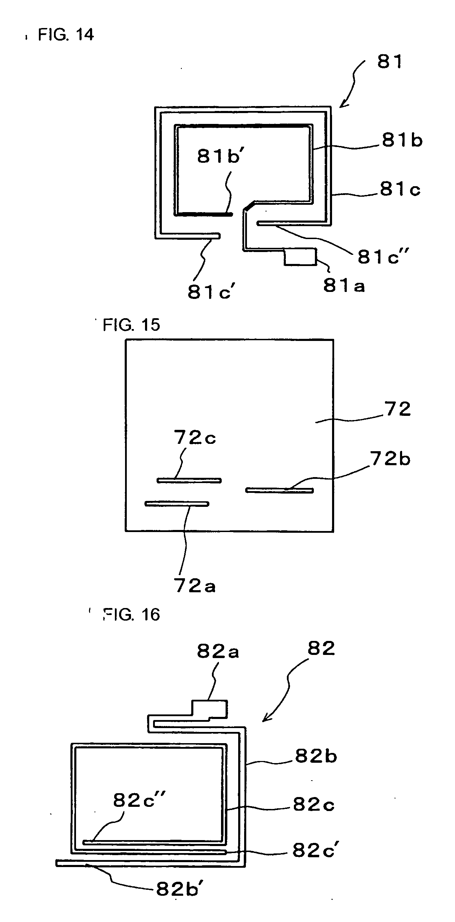

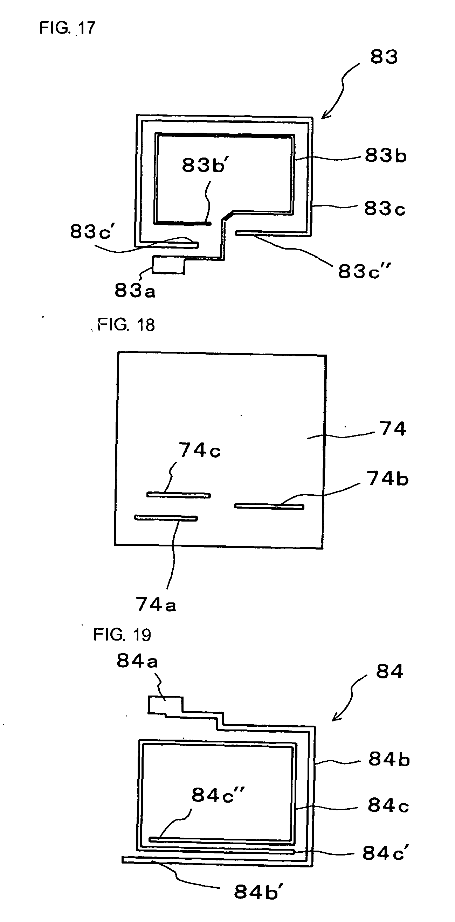

Next, a second embodiment of the invention will be described. FIG. 13 is an exploded perspective view of a laminated balun transformer according to a second embodiment of the invention. FIG. 14 is a plan view that shows a lower-layer conductive pattern of a primary coil 8-1. FIG. 15 is a plan view that shows an intermediate insulating layer 72. FIG. 16 is a plan view that shows an upper-layer conductive pattern of the primary coil 8-1. FIG. 17 is a plan view that shows a lower-layer conductive pattern of a secondary coil 8-2. FIG. 18 is a plan view that shows an intermediate insulating layer 74. FIG. 19 is a plan view that shows an upper-layer conductive pattern of the secondary coil 8-2.

As shown in FIG. 13, the laminated balun transformer according to this embodiment is formed so that a laminated body 2 that incorporates a transformer 8 is held between magnetic substrates 1 and 3, and four 4-1 to 4-4 are fitted to the side faces. Specifically, the transformer 8 is formed of a primary coil 8-1 and a secondary coil 8-2 that vertically face each other, the primary coil 8-1 is formed of a conductive pattern 81 and a conductive pattern 82, and the secondary coil 8-2 is formed of a conductive pattern 83 and a conductive pattern 84. As shown in FIG. 14, the conductive pattern 81 is formed of a pattern 81 b that includes an internal electrode 81 a extended from the inside, and an outside pattern 81c. In addition, as shown in FIG. 16, the conductive pattern 82 is formed of a pattern 82b that includes an internal electrode 82a extended to the outside, and an inside pattern 82c. Then, an end 82b' of the pattern 82b of the conductive pattern 82 is connected to an end 81c' of the pattern 81c of the conductive pattern 81 via a through-hole 72a of an insulating layer 72 shown in FIG. 15. In addition, an end 81c" of the pattern 81c is connected to an end 82c' of the pattern 82c via a through-hole 72b, and an end 82c" of the pattern 82c is connected to an end 81b' of the pattern 81b via a through-hole 72c. In this manner, the spiral primary coil 8-1 is formed so that the internal electrodes 81a and 82a serve as both ends.

The primary coil 8-1 is also formed so that the line width of the pattern 82b is largest, the line widths of the patterns 81c and 82c sequentially become smaller in this order, and the line width of the pattern 81 b is smallest, and is formed so as to be narrowed from the side of the internal electrode 82a, which is one end, toward the side of the internal electrode 81 a, which is the other end.

On the other hand, as shown in FIG. 13, the conductive patterns 83 and 84 are arranged above the conductive patterns 81 and 82 via an insulating layer 73. As shown in FIG. 17, the conductive pattern 83 is formed of a pattern 83b that includes an internal electrode 83a extended from the inside, and an outside pattern 83c. In addition, as shown in FIG. 19, the conductive pattern 84 is formed of a pattern 84b that includes an internal electrode 84a extended to the outside, and an inside pattern 84c. Then, an end 84b' of the pattern 84b of the conductive pattern 84 is connected to an end 83c' of the pattern 84c of the conductive pattern 83 via a through-hole 74a of an insulating layer 74 shown in FIG. 18. In addition, an end 83c" of the pattern 83c is connected to an end 84c' of the pattern 84c via a through-hole 74b, and an end 84c" of the pattern 84c is connected to an end 83b' of the pattern 83b via a through-hole 74c. In this manner, the spiral secondary coil 8-2 is formed so that the internal electrodes 83a and 84a serve as both ends.

The secondary coil 8-2 is also formed so that the line width of the pattern 84b is largest, the line widths of the patterns 83c and 84c sequentially become smaller in this order, and the line width of the pattern 83b is smallest, and is formed so as to be narrowed from the side of the internal electrode 84a, which is one end, toward the side of the internal electrode 83a, which is the other end.

Then, as shown in FIG. 13, the external electrode 4-1 is electrically connected to the internal electrode 82a of the conductive pattern 82, and the external electrode 4-2 is electrically connected to the internal electrode 81a of the conductive pattern 81. Then, the external electrode 4-3 is electrically connected to the internal electrode 83a of the conductive pattern 83, and the external electrode 4-4 is electrically connected to the internal electrode 84a of the conductive pattern 84.

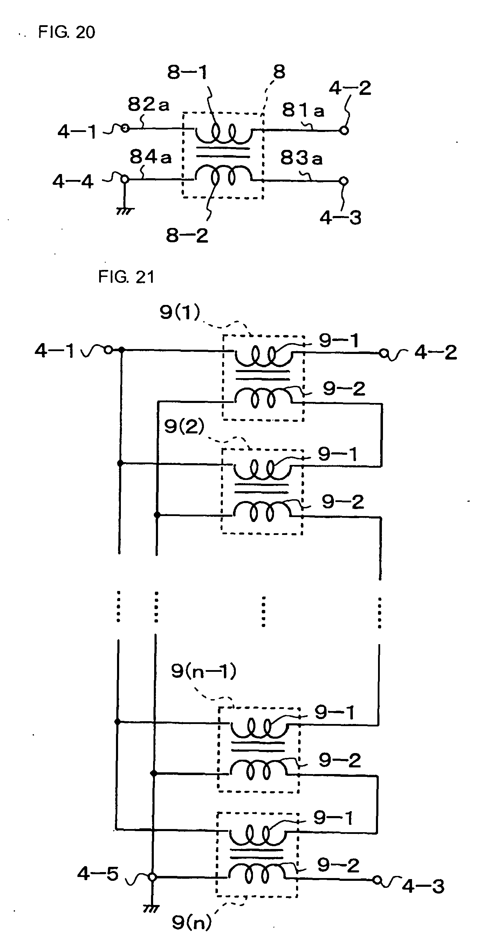

FIG. 20 is an equivalent circuit diagram of the laminated balun transformer according to the second embodiment. As shown in FIG. 20, the external electrode 4-1, which is connected to the internal electrode 82a of the primary coil 8-1, serves as an unbalance terminal, and the external electrode 4-2, which is connected to the internal electrode 61 a, serves as a first balance terminal. Then, the external electrode 4-3, which is connected to the internal electrode 83a of the secondary coil 8-2, serves as a second balance terminal, and the external electrode 4-4, which is connected to the internal electrode 84a, serves as a ground terminal, thus forming a structure similar to a 1 to 1 balun transformer. However, the laminated balun transformer of this embodiment is formed so that the line width of the primary coil 8-1 of the transformer 8 is set so as to decrease from the side of the internal electrode 82a toward the side of the internal electrode 81 a, and the line width of the secondary coil 8-2 is also set so as to decrease from the side of the internal electrode 84a toward the side of the internal electrode 83a. Thus, the ratio of an impedance of the side of the external electrode 4-1, which is the unbalance terminal, to an impedance of the sides of the external electrodes 4-2 and 4-3, which are the first and second terminals, may be set not to 1 to 1 but may be larger than 1 to 1, such as 1 to 1.5 or 1 to 2.0.

Conversely, when the external electrode 4-2 serves as an unbalance terminal, the external electrode 4-3 serves as a ground terminal, and the external electrodes 4-1 and 4-4 serve as first and second balance terminals, the ratio of an impedance of the side of the external electrode 4-2, which is the unbalance terminal, to an impedance of the side of the external electrodes 4-1 and 4-4, which are the first and second balance terminals, may be set not to 1 to 1 but may be smaller than 1 to 1, such as 1 to 0.75 or 1 to 0.5. The other configuration, function and advantageous effects are similar to those of the first embodiment, so the description thereof is omitted.

### Third Embodiment

Next, a third embodiment of the invention will be described. FIG. 21 is an equivalent circuit diagram of a laminated balun transformer according to a third embodiment of the invention. In this embodiment, as in the case of the laminated balun transformer shown in FIG. 1, in the structure in which a laminated body 2 is held between magnetic substrates 1 and 3, and external electrodes 4-1 to 4-6 are fitted to the side faces, as shown in FIG. 21, n (n is integer larger than or equal to 3) numbers of first transformer 9(1) to nth transformer 9(n) are incorporated in the laminated body 2.

Specifically, the left end of a primary coil 9-1 of the first transformer 9(1) is connected to the external electrode 4-1 to serve as an unbalance terminal, and the right end thereof is connected to the external electrode 4-2 to serve as a first balance terminal. In addition, in the last nth transformer 9(n), the left end of a secondary coil 9-2 is connected to the external electrode 4-5 to serve as a ground terminal, and the right end thereof is connected to the external electrode 4-3 to serve as a second balance terminal. Then, the left end of each of the secondary coils 9-2 of the first transformer 9(1) to (n-1) th transformer 9(n-1) is connected to the left end of the secondary coil 9-2 of the nth transformer 9(n). That is, the left ends of all the secondary coils 9-2 of the first transformer 9(1) to nth transformer 9(n) are connected to the external electrode 4-5 to serve as ground terminals. In addition, the left end of each of the primary coils 9-1 of the second transformer 9(2) to nth transformer 9(n) is connected to the left end of the left end of the primary coil 9-1 of the first transformer 9(1). That is, the left ends of all the primary coils 9-1 of the first transformer 9(1) to nth transformer 9(n) are connected to the external electrode 4-1 to serve as an unbalance terminal. Then, the right ends of the primary coils 9-1 of the second transformer 9(2) to nth transformer 9(n) are respectively connected to the right ends of the secondary coils 9-2 of the preceding transformers 9(1) to 9(n-1).

In the above electrical circuit configuration, when the line widths of the primary and secondary coils 9-1 and 9-2 are uniform, the laminated balun transformer is a 1 to n² laminated balun transformer; however, in this embodiment as well, as in the case of the above first and second embodiments, the line width of the primary coil 9-1 of the first transformer 9(1) is set so as to increase or decrease from the left end toward the right end, and the line width of the secondary coil 9-2 of the nth transformer 9(n) is set so as to increase or decrease from the left end toward the right end. That is, the line widths of these coils are increased or decreased from the unbalance terminal side toward the first and second balance terminals side. In this manner, when it is configured so that the line width of the primary coil 9-1 of the first transformer 9(1) and the line width of the secondary coil 9-2 of the nth transformer 9(n) are increased from the unbalance terminal side toward the first and second balance terminals side, the ratio of an impedance of the side of the external electrode 4-1 to an impedance of the sides of the external electrodes 4-2 and 4-3 may be smaller than 1 to n². In addition, conversely, when it is configured so that the line width is decreased from the unbalance terminal side toward the first and second balance terminals side, the ratio of an impedance of the side of the external electrode 4-1 to an impedance of the side of the external electrodes 4-2 and 4-3 may be larger than 1 to n². The other configuration, function and advantageous effects are similar to those of the first and second embodiments, so the description thereof is omitted.

Note that the invention is not limited to the embodiments described above, and it may be modified or changed in various forms within the scope of the invention. For example, in the first embodiment, the illustrated laminated balun transformer employs the coils of which the line widths are decreased from the unbalance terminal side toward the first and second balance terminals side; however, it is not limited to it. A laminated balun transformer that employs coils of which the line widths are increased from the unbalance terminal side toward the first and second balance terminals side may also be included within the scope of the invention.

## Claims

1. A laminated balun transformer comprising: a first magnetic substrate (1, 3); a laminated body (2) that incorporates a first transformer (5) and a second transformer (6), each of which is formed of a primary coil (5-1, 6-1, 8-1, 9-1) and a secondary coil (5-2, 6-2, 8-2, 9-2) that are laminated on the first magnetic substrate (1,3) and that face each other; and a second magnetic substrate (1, 3) provided on the laminated body (2), wherein
one end of the primary coil (5-1, 6-1, 8-1, 9-1) of the first transformer (5) serves as an unbalance terminal and the other end of the primary coil serves as a first balance terminal, one end and the other end of the secondary coil (5-2, 6-2, 8-2, 9-2) respectively serve as ground terminals, one end of the primary coil of the second transformer (6) is connected to the one end of the primary coil of the first transformer (5) and the other end of the primary coil of the first transformer (5) is connected to the secondary coil of the first transformer, one end of the secondary coil of the second transformer (6) is connected to the one end of the secondary coil of the first transformer and the other end of the secondary coil of the second transformer serves as a second balance terminal, and wherein
the shape of the primary coil (5-1, 6-1, 8-1, 9-1) of the first transformer (5) is set so that the line width of the primary coil of the first transformer increases or decreases from the one end toward the other end, and the shape of the secondary coil (5-2, 6-2, 8-2, 9-2) of the second transformer (6) is set so that the line width of the secondary coil of the second transformer increases or decreases from the one end toward the other end.

2. A laminated balun transformer comprising: a first magnetic substrate (1, 3); a laminated body (2) that incorporates a transformer (5, 6, 8) formed of a primary coil (5-1, 6-1, 8-1, 9-1) and a secondary coil (5-2, 6-2, 8-2, 9-2) that are laminated on the first magnetic substrate (1, 3) and that face each other; and a second magnetic substrate (1, 3) that is provided on the laminated body (2), wherein
one end of the primary coil (5-1, 6-1, 8-1, 9-1) of the transformer (5, 6, 8) serves as an unbalance terminal and the other end of the primary coil serves as a first balance terminal, and one end of the secondary coil (5-2, 6-2, 8-2, 9-2) serves as a ground terminal and the other end of the secondary coil serves as a second balance terminal, and wherein
the shape of the primary coil (5-1, 6-1, 8-1, 9-1) of the transformer (5, 6, 8) and the shape of the secondary coil (5-2, 6-2, 8-2, 9-2) of the transformer are set so that the line width of the primary coil and the line width of the secondary coil increase or decrease from the one end toward the other end.

3. A laminated balun transformer comprising: a first magnetic substrate (1, 3), a laminated body (2) that incorporates a first transformer (5, 6, 8) to an nth transformer (n is integer larger than or equal to 3), which are laminated on the first magnetic substrate (1, 3) and each of which is formed of a primary coil (5-1, 6-1, 8-1, 9-1), and a secondary coil (5-2, 6-2, 8-2, 9-2) that face each other; and a second magnetic substrate (1, 3) that is provided on the laminated body, wherein
one end of the primary coil (5-1, 6-1, 8-1, 9-1) of the first transformer (5, 6, 8) serves as an unbalance terminal and the other end of the primary coil of the first transformer serves as a first balance terminal, one end of the secondary coil (5-2, 6-2, 8-2, 9-2) of the nth transformer serves as a ground terminal and the other end of the secondary coil of the nth transformer serves as a second balance terminal, one ends of the secondary coils of the first transformer to (n-1)th transformer are connected to the one end of the secondary coil of the nth transformer, one ends of the primary coil of the second transformer to nth transformer are connected to the one end of the primary coil of the first transformer and the other ends of the primary coils of the second transformer to nth transformer are respectively connected to the other ends of the secondary coils of the preceding transformers, and wherein
the shape of the primary coil (5-1, 6-1, 8-1, 9-1) of the first transformer (5, 6, 8) is set so that the line width of the primary coil of the first transformer increases or decreases from the one end toward the other end, and the shape of the secondary coil (5-2, 6-2, 8-2, 9-2) of the nth transformer is set so that the line width of the secondary coil of the nth transformer increases or decreases from the one end toward the other end.

## Patentansprüche

1. Geschichteter Balun-Transformator, der Folgendes aufweist:
ein erstes magnetisches Substrat (1, 3); einen Schichtkörper (2), der einen ersten Transformator (5) und einen zweiten Transformator (6) enthält, die jeweils von einer primären Wicklung (5-1, 6-1, 8-1, 9-1) und einer sekundären Wicklung (5-2, 6-2, 8-2, 9-2) gebildet werden, die auf das erste magnetische Substrat (1,3) geschichtet sind und die einander zugekehrt sind; und ein zweites magnetisches Substrat (1, 3), das an dem Schichtkörper (2) bereitgestellt ist, wobei
ein Ende der primären Wicklung (5-1, 6-1, 8-1, 9-1) des ersten Transformators (5) als unsymmetrischer Anschluss dient und das andere Ende der primären Wicklung als erster symmetrischer Anschluss dient, ein Ende und das andere Ende der sekundären Wicklung (5-2, 6-2, 8-2, 9-2) jeweils als Erdanschlüsse dienen, ein Ende der primären Wicklung des zweiten Transformators (6) mit dem einen Ende der primären Wicklung des ersten Transformators (5) verbunden ist und das andere der primären Wicklung des ersten Transformators (5) mit der sekundären Wicklung des ersten Transformators verbunden ist, ein Ende der sekundären Wicklung des zweiten Transformators (6) mit dem einen Ende der sekundären Wicklung des ersten Transformators und das andere Ende der sekundären Wicklung des zweiten Transformators als zweiter symmetrischer Anschluss dient, und wobei
die Form der primären Wicklung (5-1, 6-1, 8-1, 9-1) des ersten Transformators (5) so festgelegt ist, dass die Leitungsbreite der primären Wicklung des ersten Transformators von dem einen Ende zum anderen Ende zunimmt oder abnimmt und die Form der sekundären Wicklung (5-2, 6-2, 8-2, 9-2) des zweiten Transformators (6) so festgelegt ist, dass die Leitungsbreite der sekundären Wicklung des zweiten Transformators von dem einen Ende zum anderen Ende zunimmt oder abnimmt.

2. Geschichteter Balun-Transformator, der Folgendes aufweist:
ein erstes magnetisches Substrat (1, 3); einen Schichtkörper (2), der einen Transformator (5, 6, 8) enthält, der von einer primären Wicklung (5-1, 6-1, 8-1, 9-1) und einer sekundären Wicklung (5-2, 6-2, 8-2, 9-2) gebildet wird, die auf das erste magnetische Substrat (1,3) geschichtet sind und die einander zugekehrt sind; und ein zweites magnetisches Substrat (1, 3), das an dem Schichtkörper (2) bereitgestellt ist, wobei
ein Ende der primären Wicklung (5-1, 6-1, 8-1, 9-1) des Transformators (5, 6, 8) als unsymmetrischer Anschluss dient und das andere Ende der primären Wicklung als erster symmetrischer Anschluss dient und ein Ende der sekundären Wicklung (5-2, 6-2, 8-2, 9-2) als Erdanschluss dient und das andere Ende der sekundären Wicklung als ein zweiter symmetrischer Anschluss dient, und wobei
die Form der primären Wicklung (5-1, 6-1, 8-1, 9-1) des Transformators (5, 6, 8) und die Form der sekundären Wicklung (5-2, 6-2, 8-2, 9-2) des Transformators so festgelegt sind, dass die Leitungsbreite der primären Wicklung und die Leitungsbreite der sekundären Wicklung von dem einen Ende zum anderen Ende zunimmt oder abnimmt.

3. Geschichteter Balun-Transformator, der Folgendes aufweist:
ein erstes magnetisches Substrat (1, 3); einen Schichtkörper (2), der einen ersten Transformator (5, 6, 8) bis einen n-ten Transformator (n ist eine Ganzzahl, die größer oder gleich 3 ist) enthält, die auf das erste magnetische Substrat (1,3) geschichtet sind und die jeweils von einer primären Wicklung (5-1, 6-1, 8-1, 9-1) und einer sekundären Wicklung (5-2, 6-2, 8-2, 9-2) gebildet werden, die einander zugekehrt sind; und ein zweites magnetisches Substrat (1, 3), das an dem Schichtkörper bereitgestellt ist, wobei
ein Ende der primären Wicklung (5-1, 6-1, 8-1, 9-1) des ersten Transformators (5, 6, 8) als unsymmetrischer Anschluss dient und das andere Ende der primären Wicklung des ersten Transformators als erster symmetrischer Anschluss dient, ein Ende der sekundären Wicklung (5-2, 6-2, 8-2, 9-2) des n-ten Transformators als Erdanschluss dient und das andere Ende der sekundären Wicklung des n-ten Transformators als zweiter symmetrischer Anschluss dient, die einen Enden der sekundären Wicklungen des ersten Transformators bis (n-1)-ten Transformators mit dem einen Ende der sekundären Wicklung des n-ten Transformators verbunden sind, die einen Enden der primären Wicklung des zweiten Transformators bis n-ten Transformators mit dem einen Ende der primären Wicklung des ersten Transformators verbunden sind und die anderen Enden der primären Wicklungen des zweiten Transformators bis n-ten Transformators jeweils mit den anderen Enden der zweiten Wicklungen des vorhergehenden Transformators verbunden sind, und wobei
die Form der primären Wicklung (5-1, 6-1, 8-1, 9-1) des ersten Transformators (5, 6, 8) so festgelegt ist, dass die Leitungsbreite der primären Wicklung des ersten Transformators von dem einen Ende zum anderen Ende zunimmt oder abnimmt, und die Form der sekundären Wicklung (5-2, 6-2, 8-2, 9-2) des n-ten Transformators so festgelegt ist, dass die Leitungsbreite der sekundären Wicklung des n-ten Transformators von dem einen Ende zum anderen Ende zunimmt oder abnimmt.

## Revendications

1. Transformateur symétrique-asymétrique stratifié comprenant : un premier substrat magnétique (1, 3) ; un corps stratifié (2) qui incorpore un premier transformateur (5) et un deuxième transformateur (6), chacun desquels est formé d'un enroulement primaire (5-1, 6-1, 8-1, 9-1) et d'un enroulement secondaire (5-2, 6-2, 8-2, 9-2) qui sont stratifiés sur le premier substrat magnétique (1, 3) et qui se font face l'un à l'autre ; et un deuxième substrat magnétique (1, 3) fourni sur le corps stratifié (2), dans lequel
une extrémité de l'enroulement primaire (5-1, 6-1, 8-1, 9-1) du premier transformateur (5) sert comme une borne asymétrique et l'autre extrémité de l'enroulement primaire sert comme une première borne symétrique, une extrémité et l'autre extrémité de l'enroulement secondaire (5-2, 6-2, 8-2, 9-2) servent respectivement comme des bornes de terre, une extrémité de l'enroulement primaire du deuxième transformateur (6) est raccordée à une extrémité de l'enroulement primaire du premier transformateur (5) et l'autre extrémité de l'enroulement primaire du premier transformateur (5) est raccordée à l'enroulement secondaire du premier transformateur, une extrémité de l'enroulement secondaire du deuxième transformateur (6) est raccordée à une extrémité de l'enroulement secondaire du premier transformateur et l'autre extrémité de l'enroulement secondaire du deuxième transformateur sert comme une deuxième borne symétrique, et dans lequel
la forme de l'enroulement primaire (5-1, 6-1, 8-1, 9-1) du premier transformateur (5) est établie de telle sorte que la largeur de ligne de l'enroulement primaire du premier transformateur accroît ou décroît d'une extrémité vers l'autre extrémité, et la forme de l'enroulement secondaire (5-2, 6-2, 8-2, 9-2) du deuxième transformateur (6) est établie de telle sorte que la largeur de ligne de l'enroulement secondaire du deuxième transformateur accroît ou décroît d'une extrémité vers l'autre extrémité.

2. Transformateur symétrique-asymétrique stratifié comprenant : un premier substrat magnétique (1, 3) ; un corps stratifié (2) qui incorpore un transformateur (5, 6, 8) formé d'un enroulement primaire (5-1, 6-1, 8-1, 9-1) et d'un enroulement secondaire (5-2, 6-2, 8-2, 9-2) qui sont stratifiés sur le premier substrat magnétique (1, 3) et qui se font face l'un à l'autre ; et un deuxième substrat magnétique (1, 3) qui est fourni sur le corps stratifié (2), dans lequel
une extrémité de l'enroulement primaire (5-1, 6-1, 8-1, 9-1) du transformateur (5, 6, 8) sert comme une borne asymétrique et l'autre extrémité de l'enroulement primaire sert comme une première borne symétrique, et une extrémité de l'enroulement secondaire (5-2, 6-2, 8-2, 9-2) sert comme une borne de terre et l'autre extrémité de l'enroulement secondaire sert comme une deuxième borne symétrique, et dans lequel
la forme de l'enroulement primaire (5-1, 6-1, 8-1, 9-1) du transformateur (5, 6, 8) et la forme de l'enroulement secondaire (5-2, 6-2, 8-2, 9-2) du transformateur (5, 6, 8) sont établies de telle sorte que la largeur de ligne de l'enroulement primaire et la largeur de ligne de l'enroulement secondaire accroissent ou décroissent d'une extrémité vers l'autre extrémité.

3. Transformateur symétrique-asymétrique stratifié comprenant : un premier substrat magnétique (1,3), un corps stratifié (2) qui incorpore un premier transformateur (5, 6, 8) à un n-ième transformateur (n est un nombre entier plus grand ou égal à 3), qui sont stratifiés sur le premier substrat magnétique (1, 3) et chacun desquels est formé d'un enroulement primaire (5-1, 6-1, 8-1, 9-1), et d'un enroulement secondaire (5-2, 6-2, 8-2, 9-2) qui se font face l'un à l'autre ; et un deuxième substrat magnétique (1, 3) qui est fourni sur le corps stratifié, dans lequel
une extrémité de l'enroulement primaire (5-1, 6-1, 8-1, 9-1) du premier transformateur (5, 6, 8) sert comme une borne asymétrique et l'autre extrémité de l'enroulement primaire du premier transformateur sert comme une première borne symétrique, une extrémité de l'enroulement secondaire (5-2, 6-2, 8-2, 9-2) du n-ième transformateur sert comme une borne de terre et l'autre extrémité de l'enroulement secondaire du n-ième transformateur sert comme une deuxième borne symétrique, les unes extrémités des enroulements secondaires du premier transformateur au (n-1)-ième transformateur sont raccordées à une extrémité de l'enroulement secondaire du n-ième transformateur, les unes extrémités de l'enroulement primaire du deuxième transformateur au n-ième transformateur sont raccordées à une extrémité de l'enroulement primaire du premier transformateur et les autres extrémités des enroulements primaires du deuxième transformateur au n-ième transformateur sont raccordées respectivement aux autres extrémités des enroulements secondaires des transformateurs précédents, et dans lequel
la forme de l'enroulement primaire (5-1, 6-1, 8-1, 9-1) du premier transformateur (5, 6, 8) est établie de telle sorte que la largeur de ligne de l'enroulement primaire du premier transformateur accroît ou décroît d'une extrémité vers l'autre extrémité, et la forme de l'enroulement secondaire (5-2, 6-2, 8-2, 9-2) du n-ième transformateur est établie de telle sorte que la largeur de ligne de l'enroulement secondaire du n-ième transformateur accroît ou décroît d'une extrémité vers l'autre extrémité.
